(19) **Europäisches Patentamt**
**European Patent Office**
**Office européen des brevets**

(11) **EP 2 067 221 B1**

(12) **EUROPEAN PATENT SPECIFICATION**

(45) Date of publication and mention
of the grant of the patent:
**17.11.2010 Bulletin 2010/46**

(51) Int Cl.:
**H01S 5/0625** (2006.01)

(21) Application number: **07820360.1**

(86) International application number:
**PCT/EP2007/059916**

(22) Date of filing: **19.09.2007**

(87) International publication number:
**WO 2008/034852 (27.03.2008 Gazette 2008/13)**

(54) **TUNABLE LASER WITH A DISTRIBUTED BRAGG GRATING COMPRISING A BRAGG SECTION MADE OF STRAINED BULK MATERIAL**

ABSTIMMBARER LASER MIT EINEM VERTEILTEN BRAGG-GITTER MIT EINEM AUS VERSPANNTEN BULK-MATERIAL BESTEHENDEN BRAGG-TEIL

LASER ACCORDABLE AVEC UN RÉSEAU DE BRAGG DISTRIBUÉ COMPRENANT UNE SECTION DE BRAGG FAITE DE MATÉRIAU EN VRAC CONTRAINT

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **22.09.2006 FR 0608334**

(43) Date of publication of application:
**10.06.2009 Bulletin 2009/24**

(73) Proprietor: **Alcatel Lucent**
**75008 Paris (FR)**

(72) Inventors:
• **DEBREGEAS-SILLARD, Hélène**
**78150 Le Chesnay (FR)**
• **DECOBERT, Jean**
**91620 Nozay (FR)**
• **LELARGE, François**
**75012 Paris (FR)**

(74) Representative: **Shamsaei Far, Hassan et al**
**Alcatel Lucent International**
**IP&S**
**32 Avenue Kléber**
**92707 Colombes Cedex (FR)**

(56) References cited:
**EP-A2- 0 505 289          GB-A- 2 388 707**
**US-A- 3 962 716          US-A- 5 200 969**
**US-A1- 2004 228 377**

• **CHANG YONGMAO ET AL: "Self-starting passively mode-locked tunable Cr4+: yttrium" APPLIED PHYSICS LETTERS, AIP, AMERICAN INSTITUTE OF PHYSICS, MELVILLE, NY, US, vol. 73, no. 15, 12 October 1998 (1998-10-12), pages 2098-2100, XP012021119 ISSN: 0003-6951**
• **JEAN-PIERRE WEBER ET AL: "An Integratable Polarization-Independent Tunable Filter for WDM Systems: The Multigrating Filter" JOURNAL OF LIGHTWAVE TECHNOLOGY, XX, XX, vol. 14, no. 12, December 1996 (1996-12), XP011028732 ISSN: 0733-8724**

**Description**

The field of the invention is that of tunable lasers with a distributed Bragg grating. These lasers are used notably in optical telecommunication networks based on wavelength multiplexing, also called WDM (Wavelength Division Multiplexing). Of course, the subject of the invention may be extended to any semiconductor optical device possessing a Bragg section wavelength-tunable by injection of a current.

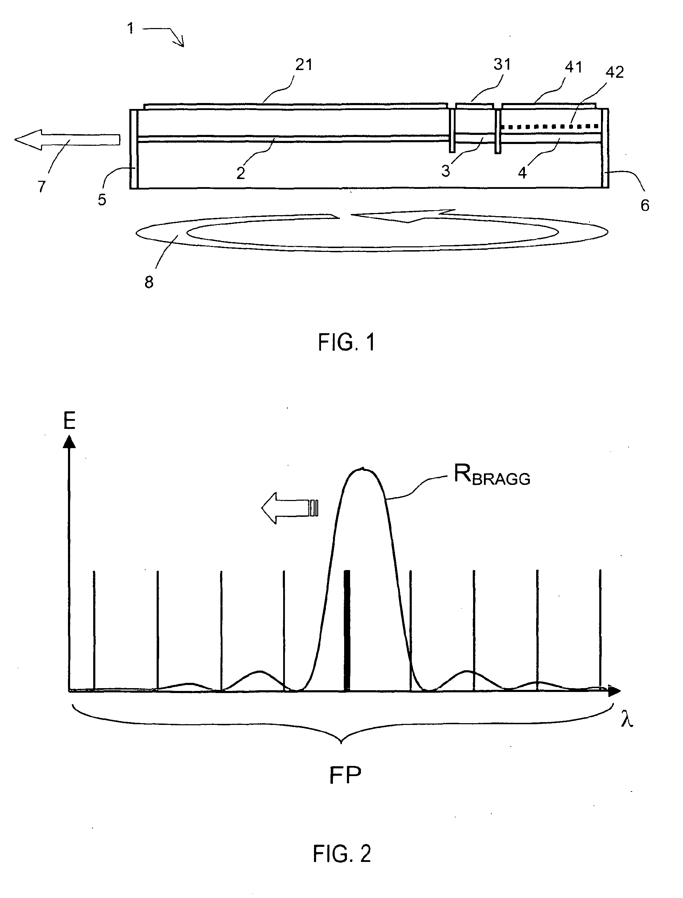

Tunable lasers with a distributed Bragg grating are also known as DBR (Distributed Bragg Reflector) lasers. As shown in figure 1, a DBR laser 1 is a component monolithically integrating three sections each controlled by a different current, namely an active section 2 and two passive sections, a phase section 3 and a Bragg section 4. The current is supplied to the various sections by means of the electrodes 21, 31 and 41.

The front face 5 and the rear face 6 of the laser 1 are treated. The reflectivity of the rear face 6 is very low, of the order of 0.01%, while the reflectivity of the front face 5 is equal to about 3%. A Fabry-Pérot cavity is thus created between the front face 5 and the equivalent mirror of the Bragg section 4.

The active section 2 is the amplifying medium which provides the cavity with gain via a current $I_{active}$ and allows the emission of a comb of FP modes, the distribution of which is imposed by the optical characteristics of the Fabry-Pérot cavity. This comb of modes is shown in figure 2.

The Bragg section 4 is composed mainly of a material that is not absorbent at the operating wavelength and comprises a Bragg grating 42, that is to say a periodic variation of the effective index. This structure behaves as a filter in reflection, centered on the wavelength $\lambda_{Bragg}$, given by the conventional equation:

$$\lambda_{Bragg} = 2n_{eff}\Lambda,$$

where $n_{eff}$ is the effective index of the guide and $\Lambda$ is the period of the Bragg grating.

The variation of the reflection coefficient $R_{Bragg}$ of this Bragg filter as a function of the wavelength is shown in figure 2. When a current $I_{Bragg}$ is injected, the carrier density increases, thereby reducing the effective index and consequently the wavelength $\lambda_{Bragg}$. The curve of variation of the reflection coefficient $R_{Bragg}$ is thus shifted.

Tunability is based on this principle, as shown in figure 2. The laser emission takes place on the FP mode having the highest reflectivity on the Bragg filter. This mode selected by the filter is shown in bold in figure 2. When the Bragg filter is tuned by injecting current into the Bragg section, the FP modes are then emitted in succession, tunability being obtained by mode jumps. When current is injected into the phase section, the effective index decreases in the same way as the effective index of the Bragg section, thereby shifting the comb of FP modes toward shorter wavelengths and thus allowing fine tuning of the emission wavelength. It is thus possible to attain all the wavelengths covered by the tunability of $\lambda_{Bragg}$. This is referred to as quasi-continuous tuning.

By these means, it is possible to vary the emission wavelength of a DBR tunable laser over a $\Delta\lambda_{Bragg}$ range of 16 nanometers.

To summarize, a mode 8, imposed by the Bragg section, oscillates in the cavity between the front and rear faces, this mode being symbolized by a semicircular arrow in figure 1, and the laser emission 7 of a fraction of this radiation takes place via the front face 5.

However, for a number of applications, in particular in the field of optical telecommunications, the tunability range obtained is insufficient. For example, a tunability of around 35 nanometers is needed to cover the entire C-band (1528 nm-1562 nm) or the entire L-band (1570 nm-1605 nm) in optical telecommunications. Currently, to achieve this wide range of tunability, it is necessary either to use the interaction between more sophisticated gratings, such as sampled gratings or gratings in which the period varies periodically, or to use a succession of Bragg gratings with offset periods, or to add the tunability ranges of several DBR lasers, for example, using a coupler.

The object of the invention is to increase the tunability range of the Bragg section of the DBR or any other section sufficiently, using the variation of carriers by current injection. Notably, this makes it possible to simplify the design of the final component. Thus, it is possible:

- to cover the C- or L-band with a single component;
- to use only two DBR lasers instead of three;
- to obtain greater tolerance on the characteristics and the fabrication of sampled gratings, etc.; and
- to reduce the currents needed in the Bragg sections. Thus ultrarapid tunability of the order of a few nanoseconds is obtained.

The core of the invention is to produce the Bragg section from a strained material. It will be demonstrated that one of the effects, called band filling, is substantially modified by acting on the wavelength tunability range $\Delta\lambda_{Bragg}$.

More precisely, the subject of the invention is a tunable multisection semiconductor laser device with an active section, a phase control section, and a distributed Bragg grating, comprising a Bragg passive section consisting of a material whose optical index variations are controlled by an injection current, wherein said material of the Bragg section is a strained material composed of layers of the same material, each layer having a lattice parameter and at least two layers having a different lattice parameter so as to lift the degeneracy between the light hole bands and the heavy hole bands.

Advantageously, the strain of the material is equal to the relative variation of the lattice parameter between the various layers.

Advantageously, the strain applied to the material is at least 0.1%; the material comprises a succession of layers, some strained and the others unstrained.

Advantageously, the strain is exerted in compression or in tension. Advantageously, the material is a quaternary material, the quaternary material being InGaAsP, the wavelength corresponding to the maximum photoluminescence then has a value of 1.45 $\mu$m, said material being known by the name Q 1.45.

Preferably, this device applies to DBR-type tunable lasers.

The invention will be more clearly understood and other advantages will become apparent on reading the following description given by way of nonlimiting example and thanks to the appended figures in which:

- figure 1 shows a general view of a tunable laser with a distributed Bragg grating;
- figure 2 shows the principle of tunability by means of a tunable Bragg grating;
- figure 3 shows the variation of the absorption of the material as a function of the energy;
- figure 4 shows the energy band diagram for an unstrained bulk material;
- figure 5 shows the energy band diagram for a strained bulk material;
- figure 6 shows the energy band diagram for a bulk material under extension; and
- figure 7 shows the index variation as a function of the wavelength for lattice-matching materials, in compression or in tension.

The tunability of the DBR is given by the following equation:

$$\Delta\lambda_{Bragg} = 2.\Gamma_Q \frac{dn_Q}{dN} \Delta N \Lambda,$$

where $\Gamma_Q$ is the confinement of the optical mode in the guide material in which the carriers are located, $\Delta N$ is the variation in carrier density associated with the current injection and $dn_Q/dN$ is the variation in index of the material with carrier density.

The object of the invention is to broaden $\Delta\lambda_{Bragg}$ by increasing the index variation of the material with the carrier density $dn_Q/dN$. However, to maintain a maximum confinement factor $\Gamma_Q$ of around 70%, it is necessary to employ a thick bulk material or one possibly having a few interposed thin layers. Quantum-well structures degrade the factor $\Gamma_Q$ too much to be used. The index variation $dn_Q/dN$ is the sum of three main effects, which are:

- the plasma effect;
- bandgap renormalization, also called bandgap shrinkage;
- band filling.

The first two effects do not depend on modifiable parameters of the material. The objective of the invention is therefore to increase the band filling effect.

The absorption of a photon involving an electron going from the valence band with an energy $E_V$ to the conduction band with an energy $E_C$ is possible only if the level $E_V$ is occupied and the level $E_C$ is free. The absorption may be modeled by:

$$\alpha(E) = \frac{C_{hh}}{E}\sqrt{E-E_g}\left[f_v\left(E_{vh}\right)-f_c\left(E_{ch}\right)\right] + \frac{C_{lh}}{E}\sqrt{E-E_g}\left[f_v\left(E_{vl}\right)-f_v\left(E_{cl}\right)\right],$$

where $C_{hh}$ and $C_{lh}$ are the absorption coefficients for the transitions coming from bands carrying light holes and heavy holes, respectively. They are characteristic of the material.

$E_{ve}$ and $E_{ch}$ correspond to the transition energies from the band of the heavy holes, whereas $E_{vl}$ and $E_{cl}$

correspond to the transition energies from the band of the light holes. $f_v(E)$ and $f_c(E)$ are the probabilities of an energy level E of the valence band or the conduction band being occupied by an electron, respectively.

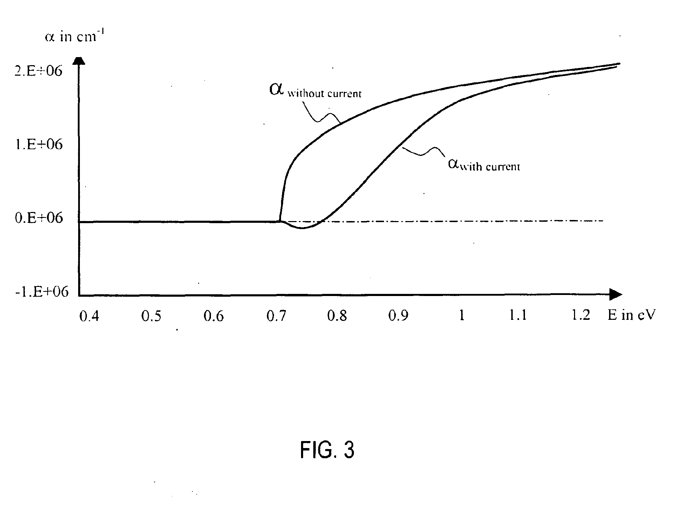

When current is injected, the bands fill up with carriers. At energies slightly above the gap energy $E_g$, the terms $f_v(E) - f_c(E)$ becomes zero or negative. The result obtained at these energies is a reduction in the absorption and possibly even in the gain. This effect is illustrated in figure 3, where the absorption as a function of the energy is plotted with and without injection of carriers.

Now, the variation in index of the material at an energy $E_0$ is tied to the variation in absorption of this material over the entire energy spectrum by the Kramers-Krönig relation:

$$\Delta n(E_0) = \frac{\hbar c}{\pi} PV \int_0^\infty \frac{\Delta \alpha(E)}{E^2 - E_0^2} dE,$$

in which PV represents the cauchy principal value and $E_0$ represents work energy. A substantial reduction in the optical index around $E_g$ is thus obtained. For example, for a DBR laser with an operating wavelength of 1.5 $\mu$m, the energy $E_0$ is equal to 0.8 eV.

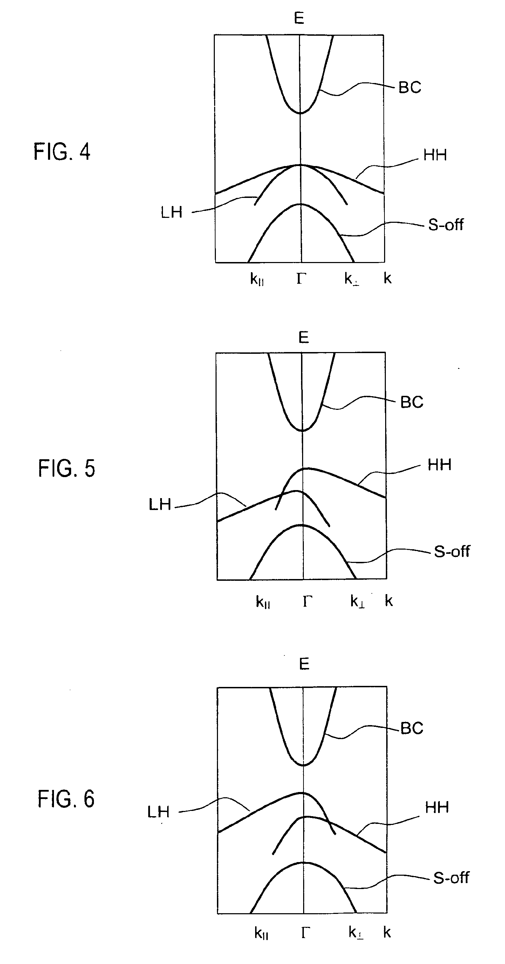

To increase the band filling effect, it is therefore necessary to accentuate this absorption reduction at energies close to the gap. To do this, strained materials are used. Figures 4, 5 and 6 show the energy diagrams of a bulk direct-gap semiconductor material as a function of the momentum in the direction k// direction parallel to the growth direction and in the direction k⊥ direction perpendicular to the growth direction.

In these figures, the conduction band is denoted by BC, the heavy hole band and the light hole band are denoted by HH and LH respectively, and the split-off band is denoted by S-off.

Figure 4 corresponds to a material with lattice matching. The material is isotropic - the bands are identical in the k// and k⊥ directions. The light hole bands LH and the heavy hole bands HH have the same energy levels - they are degenerate. The injected carriers are therefore distributed in both bands.

To increase the variation in absorption, and in particular the band filling, the principle of the device according to the invention is to lift the degeneracy between the light hole bands and the heavy hole bands. The carriers are therefore distributed in only one band, allowing greater reduction in the absorption. Moreover, lifting the degeneracy will involve either reducing the effective mass of the heavy holes or reducing the effective mass of the light holes making the HH or LH band in question narrower by this reduction, thus promoting carrier filling up to high energies.

To achieve this strain, it is possible to apply a biaxial strain to the material of the Bragg section.

In the case of a compressive strain, the heavy hole band HH becomes higher in energy, as indicated in figure 5 - the injected carriers are preferentially distributed in the HH band. Moreover the effective mass of the heavy holes is lower, which corresponds to a narrower energy band HH in the $k_\parallel$ direction, as indicated in figure 5. This effect results in more rapid filling of the heavy hole band, further increasing the band filling effect. In these structures in compression, a large variation in the absorption involving heavy holes, that is to say corresponding to a transverse electric polarization denoted by TE of the optical mode, is therefore obtained. In a conventional DBR laser, the light emitted by the gain section is effectively polarized in TE mode. In contrast, for light polarized in transverse magnetic mode denoted by TM, the band filling effect is small.

In the case of a tensile strain, the light hole band LH becomes higher in energy, as indicated in figure 6. The injected carriers are distributed in the LH band. In this case, what is therefore obtained is a high band filling effect for the TM polarization and a low band filling effect in the TE polarization. To be used in a DBR, this type of material therefore requires an active structure suitable for emitting in TM mode.

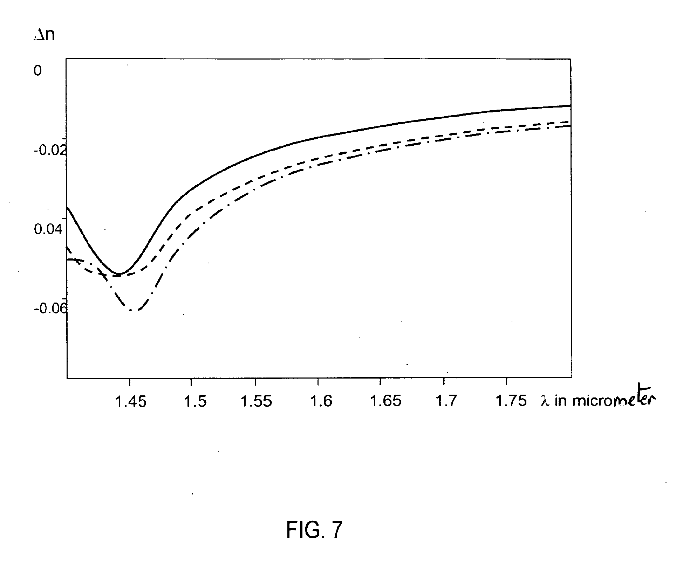

Figure 7 gives the results of simulating the index variation $\Delta n$ as a function of the wavelength $\lambda$, which variation is due solely to the band filling effect and is obtained for a carrier density of $2 \times 10^{18}$ cm$^{-3}$. The solid curve corresponds to an unstrained bulk material. The dashed curve corresponds to a strained bulk material with a compressive strain of +1%: a 25% improvement in the index variation is obtained at the operating wavelength of 1.55 $\mu$m, which means a 25% increase in tunability. For a material with a tensile strain of -0.7%, corresponding to the dot-dash curve, a 45% increase in the index variation is obtained, provided that the operation is in TM mode. Various types of materials exist for producing a strained Bragg section. For example, it is possible to use MQW (multiple quantum well) structures. However, it is not possible to produce MQW structures with confinement levels $\Gamma_Q$ as high as in bulk materials, since the carriers are not stored in the barriers that therefore do not participant in the tunability. Typically, the maximum values of $\Gamma_Q$ in the wells are about 35%, as opposed to 70% in the bulk material. Consequently, it is preferable to use a bulk material in order to produce a Bragg section according to the invention so as to achieve a high confinement level.

The production of a strained bulk material is a standard technique. It consists in depositing layers of material, for example by epitaxial processes, with different lattice parameters. Biaxial strains are thus created, either in compression or in tension, depending on whether the lattice parameter between the various layers increases or decreases. Depending on the material used and on its thickness, there is a maximum strain threshold above which mechanical relaxation and dislocation mechanisms may appear. To push back these limits, it is possible to insert thin layers of opposite strain, for example layers in tension in a material in compression, so as to compensate for the mechanical effects. Preferably, the strain applied to the bulk material may reach a few tenths of a percent.

## Claims

1. A tunable multisection semiconductor laser device, so as to lift the degeneracy between the light hole bands and the heavy hole bands with an active section (2), a phase control section (3), and a distributed Bragg grating, comprising a passive Bragg section (4) consisting of a material whose optical index variations are controlled by an injection current, wherein said material of the passive Bragg section is a strained material composed of bulky layers of the same material, each layer having a lattice parameter and, at least two layers having a different lattice parameter, so as to lift the degeneracy between the light hole bands and the heavy hole bands.

2. The tunable semiconductor laser device with a distributed Bragg grating as claimed in claim 1, wherein the strain of the material being equal to the relative variation of the lattice parameter between the various layers.

3. The tunable semiconductor laser device with a distributed Bragg grating as claimed in claims 1, wherein the strain applied to the material is at least 0.1 %.

4. The tunable semiconductor laser device with a distributed Bragg grating as claimed in either of claims 1 or 3, wherein the material comprises a succession of layers, some strained and the others unstrained.

5. The tunable semiconductor laser device with a distributed Bragg grating as claimed in one of the preceding claims, wherein the strain is exerted in compression.

6. The tunable semiconductor laser device with a distributed Bragg grating as claimed in claims 1 to 4, wherein the strain is exerted in tension.

7. The tunable semiconductor laser device with a distributed Bragg grating as claimed in one of the preceding claims, wherein the strained material is a quaternary material.

8. The tunable semiconductor laser device with a distributed Bragg grating as claimed in claim 7, wherein the quaternary material is InGaAsP, the wavelength corresponding to the maximum photoluminescence having a value of 1.45 $\mu$m, said quaternary material being known by the name Q 1.45.

## Patentansprüche

1. Eine abstimmbare Halbleiter-Laservorrichtung mit mehreren Abschnitten (1), um die Degeneration zwischen den leichten Lochbändern und den schweren Lochbändern aufzuheben, mit einem aktiven Abschnitt (2), einem Phasensteuerungsabschnitt (3) und einem verteilten Bragg-Gitter, umfassend einen passiven Bragg-Abschnitt (4) bestehend aus einem Material, dessen Veränderungen des optischen Index von einem Injektionsstrom gesteuert werden, wobei das besagte Material des passiven Bragg-Abschnitts ein verspanntes Material bestehend aus Volumenschichten desselben Materials ist, wobei jede Schicht einen Gitterparameter aufweist, und wobei mindestens zwei Schichten einen verschiedenen Gitterparameter (5) aufweisen.

2. Die abstimmbare Halbleiter-Laservorrichtung mit einem verteilten Bragg-Gitter nach Anspruch 1, wobei die verspannung des Materials der relativen Veränderung des Gitterparameters zwischen den verschiedenen Schichten entspricht.

3. Die abstimmbare Halbleiter-Laservorrichtung mit einem verleilten Bragg-Gitter nach Anspruch 1, wobei die auf das Material angewendete Verspannung mindestens 0,1 % beträgt.

4. Die abstimmbare Halbleiter-Laservorrichtung mit einem verteilten Bragg-Gitter nach Anspruch 1 oder 3, wobei das Material eine Folge von Schichten umfasst, von denen einige verspannt und die anderen unverspannt sind.

**5.** Die abstimmbare Halbleiter-Laservorrichtung mit einem verteilten Bragg-Gitter nach einem der vorstehenden Ansprüche, wobei die Verspannung durch Kompression ausgeübt wird.

**6.** Die abstimmbare Halbleiter-Laservorrichtung mit einem verteilten Bragg-Gitter nach den Ansprüchen 1 bis 4, wobei die Verspannung durch Spannung ausgeübt wird.

**7.** Die abstimmbare Halbleiter-Laservorrichtung mit einem verteilten Bragg-Gitter nach einem der vorstehenden Ansprüche, wobei das verspannte Material ein quaternäres Material ist.

**8.** Die abstimmbare Halbleiter-Laservorrichtung mit einem verteilten Bragg-Gitter nach Anspruch 7, wobei das quaternäre Material InGaAsP ist, wobei die der maximalen Photolumineszenz entsprechende Wellenlänge einen Wert von 1,45 $\mu$m aufweist, wobei das besagte quaternäre Material unter der Bezeichnung Q 1.45 bekannt ist.

**Revendications**

**1.** Appareil laser semi-conducteur multisection accordable (1) avec une section active (2), une section de contrôle de phase (3) et un réflecteur de Bragg distribué, comprenant une section de Bragg passive (4) constituée d'un matériau dont les variations d'indice optique sont contrôlées par un courant d'injection, dans lequel ledit matériau de la section de Bragg passive est un matériau contraint composé de couches épaisses du même matériau, chaque couche ayant une constante de réseau et, au moins deux couches ayant une constante de réseau différente, pour lever le risque de dégénérescence entre les bandes de trous légers et les bandes de trous lourds.

**2.** Appareil laser semi-conducteur accordable, avec un réflecteur de Bragg distribué, selon la revendication 1, dans lequel la contrainte du matériau est égale à la variation relative de la constante de réseau entre les diverses couches.

**3.** Appareil laser semi-conducteur accordable, avec un réflecteur de Bragg distribué, selon la revendication 1, dans lequel la contrainte appliquée au matériau est d'au moins 0,1 %.

**4.** Appareil laser semi-conducteur accordable, avec un réflecteur de Bragg distribué, selon les revendications 1 ou 3, dans lequel le matériau comprend une succession de couches, certaines étant contraintes et les autres étant non contraintes.

**5.** Appareil laser semi-conducteur accordable, avec un réflecteur de Bragg distribué, selon l'une quelconque des revendications précédentes, dans lequel la contrainte est appliquée par compression.

**6.** Appareil laser semi-conducteur accordable, avec un réflecteur de Bragg distribué, selon les revendications 1 à 4, dans lequel la contrainte est appliquée par tension.

**7.** Appareil laser semi-conducteur accordable, avec un réflecteur de Bragg distribué, selon l'une quelconque des revendications précédentes, dans lequel le matériau contraint est un matériau quaternaire.

**8.** Appareil laser semi-conducteur accordable, avec un réflecteur de Bragg distribué, selon la revendication 7, dans lequel le matériau quaternaire est InGaAsP, la longueur d'onde correspondant à la photoluminescence maximale avec une valeur de 1,45 $\mu$m, ledit matériau quaternaire étant connu sous le nom de Q 1.45.

FIG. 1

FIG. 2

FIG. 3

FIG. 4

FIG. 5

FIG. 6

FIG. 7